# EUROPEAN PATENT APPLICATION

(11) **EP 2 706 665 A1**
(43) Date of publication of application: **12.03.2014**
(21) Application number: 12183255.4
(22) Date of filing: 06.09.2012
(51) Int. Cl.: H03K 17/082

(54) **Active clamp for a semiconductor switch**

(71) Applicant: ABB Oy, 00380 Helsinki (FI)
(72) Inventor: Saarinen, Mikko, 00380 Helsinki (FI)
(74) Representative: Kolster Oy Ab

(57) **Abstract**

The present invention discloses a method for an arrangement comprising a first semiconductor switch and a driver unit controlling the switch. The method detects an overvoltage over the semiconductor switch, and adjusts a voltage at a supply voltage input of the driver unit on the basis of the overvoltage.

## Description

### FIELD OF THE INVENTION

The invention relates to semiconductor switches, and particularly to controlling surge voltages over semiconductor switches.

### BACKGROUND INFORMATION

Semiconductor switches (IGBT, MOSFET, etc.) are widely used, particularly in power electronics. The switches are typically adapted to operate in one of two states: a conducting state and a non-conducting state. A driver unit is typically used to control the switch to one state or the other. To accomplish this, the driver unit supplies a control signal to a control terminal of the switch. In the case of, for example, an IGBT switch, the control signal can be a voltage which is supplied to the gate terminal of the IGBT switch.

In simplified terms, the control signal has two levels: one for the conducting state of the switch and another for the non-conducting state of the switch. In the conducting state, the current can flow through the switch, while in the non-conducting state the current is not able to flow as the switch is in a high-impedance state. The switch can be set from one state to another by changing the control signal from one level to the other.

In practice, however, changing the state of the switch may be more complex. For example, turning off a semiconductor switch when it is driving a high current inductive load may induce a shut-off voltage surge which may damage the switch.

In order to safely turn off the switch, a rate of the turn-off of the switch can be controlled by adjusting the control signal controlling the switch. The switch can, for example, be controlled with an external driver unit which detects a high current during the turn-off. When the high current is detected, the driver unit can select a slower turn-off rate for the control signal. Applying a slower rate of change of the control signal can reduce a rate of change in the current flowing through the switch, which, in turn, can reduce a peak voltage of the voltage surge. However, detecting the high current and changing to a slower turn-off rate is not instantaneous. While detecting the high current and changing to the slower turn-off rate, the surge voltage may be able to rise to an excessively high level.

Another approach is to drive a gate voltage of a semiconductor switch directly to the collector-emitter voltage of the switch when a voltage surge occurs. This can reduce the rate of change of the gate voltage. This reduces the rate of change in the current, which, in turn, reduces the peak voltage of the voltage surge. During a voltage surge, the collector-emitter voltage can, for example, drive the gate voltage directly through zener diodes and resistors, thus, allowing a faster reaction to the surge voltage. However, this approach can also cause high power losses as two sources try to drive the gate voltage to two different voltages.

### BRIEF DISCLOSURE

An object of the present invention is to provide a method and an arrangement for implementing the method so as to alleviate the above disadvantages. The objects of the invention are achieved by a method and an arrangement which are characterized by what is stated in the independent claims. The preferred embodiments of the invention are disclosed in the dependent claims.

The disclosed method and arrangement detect an overvoltage over the semiconductor switch (IGBT, MOSFET, etc.), and adjust a control signal controlling the switch on the basis of the overvoltage. The overvoltage can, for example, be detected by comparing the collector-emitter voltage of a switch to a set voltage limit. When the limit is exceeded, the disclosed method and arrangement adjust the voltage at a driver unit supply voltage input used for generating the off-state of the control signal. The voltage at the supply voltage input can, for example, be adjusted by controlling the impedance between the supply voltage input and a power source supplying the input. The impedance can be adjusted, for example, by placing a semiconductor switch in parallel with a resistor in the path between the power source and the supply input. Alternatively, the voltage can be adjusted by simply disconnecting the source.

In this manner, the disclosed method and apparatus are able to quickly react to a voltage surge. Since only the driver unit drives the control signal, the power consumption can be kept at a relatively low level. The disclosed method and apparatus can be implemented in a cost-effective manner. The driver unit controlling the semiconductor switch can be a simple gate driver unit without high current detection.

### BRIEF DESCRIPTION OF THE DRAWINGS

In the following, the invention will be described in greater detail by means of preferred embodiments with reference to the attached drawings, in which
Figure 1 is a simplified block diagram illustration of an exemplary implementation of the disclosed method;
Figure 2 illustrates an exemplary arrangement implementing the disclosed method; and
Figure 3 illustrates another exemplary arrangement implementing the disclosed method.

### DETAILED DISCLOSURE

In order to avoid a damage to the switch caused by a voltage surge, the disclosed method can first detect an overvoltage over the semiconductor switch. The disclosed method can then adjust, on the basis of the overvoltage, a control signal controlling the switch.

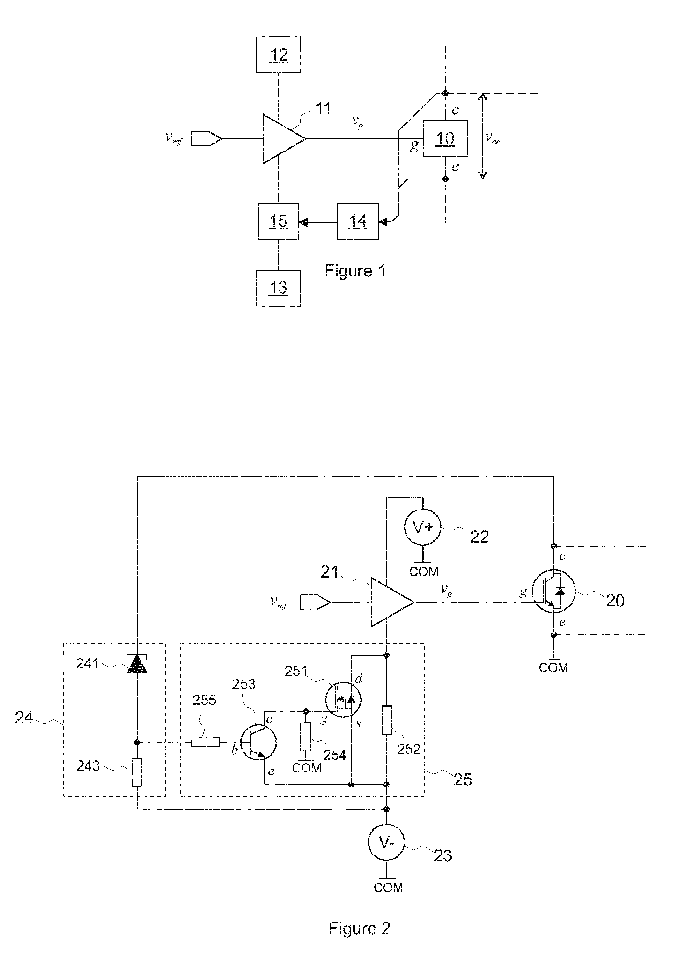

Figure 1 is a simplified block diagram illustration of an exemplary implementation of the disclosed method. The arrangement in Figure 1 comprises a first semiconductor switch 10, and a driver unit 11. In Figure 1, the semiconductor switch 10 comprises a first terminal *c*, a second terminal *e*, and a third terminal *g*. The first switch 10 is adapted to control a current between the first terminal *c* and second terminal *e* on the basis of a control signal *v_{g}* supplied to the third terminal *g*. The control signal *v_{g}* has a first level for controlling the first switch 10 to a conducting state and a second level for controlling the first switch 10 to a non-conducting state.

The driver unit 11 comprises an output providing the control signal *v_{g}* to the third terminal *g* of the first switch 10, a first supply voltage input *v_{cc}* for providing an upper limit level of an operational range of the control signal *v_{g}*, and a second supply voltage input *vₑₑ* for providing a lower limit level of the operational range of the control signal *v_{g}.* The level of the control signal *v_{g}* can thus vary between the upper and lower limit levels. The control signal *v_{g}* is controlled on the basis of a reference signal *v_{ref}.* In order for the driver unit 11 to be able to produce the control signal levels, the arrangement in Figure 1 further comprises means for supplying a first voltage to the first supply voltage input and a second voltage to the second supply voltage input. In Figure 1, these means are power supplies 12 and 13 which are connected to first and second supply voltage inputs, respectively.

The arrangement in Figure 1 further comprises means 14 for determining an overvoltage between the first terminal *c* and the second terminal *e* of the first switch 10, and means 15 for adjusting the voltage at the second supply voltage input on the basis of the overvoltage between the first terminal *c* and the second terminal *e* of the first switch 10.

The means 14 for determining the overvoltage may, for example, comprise means for comparing a voltage *v_{ce}* between the first terminal *c* and the second terminal *e* to a set voltage level, and means for producing an overvoltage detection signal on the basis of the comparison. In one simple form, the comparison can be accomplished by a circuitry where a zener diode is connected between the first terminal *c* and the second terminal *e* of the first switch 10. The circuitry is configured such that when the voltage *v_{ce}* between the first terminal *c* and the second terminal *e* rises above the breakdown voltage of the zener diode, the zener diode starts to conduct current. The current through the zener diode can then be used for producing an indicator signal indicating overvoltage.

The disclosed method is not limited to the above implementation of the means for determining the overvoltage. Other implementations can also be used. The overvoltage can, for example, be detected by using a comparator circuit which compares the voltage *v_{ce}* between the first terminal *c* and the second terminal *e* with a reference voltage.

The means 15 for adjusting the second voltage may, for example, comprise means for adjusting an impedance of a connection between the second voltage supply input and the means for supplying the second voltage on the basis of the overvoltage between the first terminal and the second terminal. The impedance can, for example, be adjusted by placing a second semiconductor switch in parallel with a resistor in the path between the means 13 for supplying the second voltage and the second voltage supply input *vₑₑ.*

Alternatively, the means 15 for adjusting the second voltage can comprise means for disconnecting a connection between the second voltage supply input and the means 13 for supplying the second voltage on the basis of the overvoltage between the first terminal and the second terminal.

The means for adjusting in disclosed method are not limited to the above implementations. Other implementations can also be used.

Figure 2 illustrates an exemplary arrangement implementing the disclosed method. The arrangement comprises a first switch, i.e. an IGBT 20, and a driver unit, i.e. a gate driver unit 21. The IGBT switch has a first terminal, i.e. a collector terminal *c*, a second terminal, i.e. an emitter terminal *e*, and a third terminal, i.e. a gate terminal *g.* A current between the collector terminal *c* and the emitter terminal *e* is controlled on the basis of a control signal supplied to the gate terminal *g.* In Figure 2, the control signal is a control voltage *v_{g}* which has a first level for driving the IGBT 20 to a conducting state and a second level for driving the IGBT 20 to a non-conducting state.

The gate driver unit 21 comprises an output providing the control voltage to the gate terminal *g* of the IGBT 20. The gate driver unit 21 is connected to the gate terminal *g* of the IGBT 20. In the embodiment of Figure 2, the gate driver unit 21 may also comprise a gate resistor. The gate driver unit 21 controls the level of the control signal *v_{g}* on the basis of a reference signal *v_{ref}* which the gate driver unit 21 receives as a voltage at its reference input terminal.

The gate driver unit further comprises a first supply voltage input *v_{cc}* for providing an upper voltage level which can be used for producing the first level of the control voltage *v_{g},* and a second supply voltage input *vₑₑ* for providing an lower voltage level which can be used for producing the second level of the control voltage *v_{g}.* A positive voltage source 22 and a negative voltage source 23 act as means for supplying a first voltage to the first supply voltage input *v_{cc}* and a second voltage to the second supply voltage input *vₑₑ,* respectively. The positive voltage source 22 and the negative voltage source 23 are connected to the common ground COM which is also connected to the second terminal of the IGBT 20.

In Figure 2, the arrangement further comprises means 24 for determining an overvoltage between the collector terminal *c* and the emitter terminal *e* of the IGBT 20, and means 25 for adjusting the voltage at the second supply voltage input *vₑₑ* on the basis of the overvoltage between the collector terminal *c* and the emitter terminal *e* of the IGBT 20.

The means 24 for determining an overvoltage are implemented by a series connection of a zener diode 241 and a resistance 242 between the collector terminal *c* and the emitter terminal *e* of the IGBT 20. The zener diode 241 acts as the means for comparing the voltage between the first terminal and the second terminal, i.e. the collector-emitter voltage *v_{ce},* to a set voltage level, while the resistor 242 acts as the means for producing an overvoltage detection signal on the basis of the comparison. The zener diode 241 is configured to conduct current when the collector-emitter voltage *v_{ce}* exceeds a set voltage level, and the resistance 242 is configured to produce an overvoltage detection voltage *vₒᵥ* responsive to the current through the zener diode 241.

In Figure 2, the series connection is connected between the collector terminal *c* and the emitter terminal *e* of the IGBT 20 through the negative voltage source 23 and the common ground COM. In other words, the set voltage, i.e. breakdown voltage of zener diode 241, can be the difference between a desired overvoltage indication level for the collector-emitter voltage *v_{ce}* and the voltage of the negative voltage source 23.

In Figure 2, the means 25 for adjusting the voltage at the second supply voltage input *vₑₑ* are implemented by a parallel connection of a second semiconductor switch 251 and a resistance 252 between the second supply voltage input and the negative voltage source 23. In Figure 2, the second semiconductor switch 251 is an N-channel MOSFET comprising a source terminal, a drain terminal and a gate terminal. The parallel connection acts as means for adjusting the impedance of the connection between the second voltage supply input and the negative voltage source 23.

By using the parallel connection, the resistance between the second supply voltage input *vₑₑ* of the gate driver unit 21 and the negative voltage source 23 can be adjusted on the basis of the collector-emitter voltage *v_{ce}* of the IGBT 20. The second switch 251 is configured to switch between a conducting state and a non-conducting state responsive to the collector-emitter voltage *v_{ce}* of the IGBT 20 in such a manner that when the collector-emitter voltage *v_{ce}* exceeds a set voltage level, the second switch switches 251 into a non-conducting state.

When the second switch 251 switches into the non-conducting state, the resistance of the connection between the second supply voltage input *vₑₑ* and the negative voltage source 23 increases. The increase in the resistance slows the rate of change of the voltage at the gate terminal of the first switch 20. The slower rate of change can then reduce the voltage surge between the first terminal and the second terminal of the first switch 20.

As illustrated in Figure 2, a third semiconductor switch 253 can be used for controlling the second switch 251 on the basis of the overvoltage. The third switch 253 is connected in parallel with a resistor 254 to a gate terminal of the second switch 251 in order to control a gate-source voltage, i.e. a voltage between the gate terminal and the source terminal of the second switch 251. In Figure 2, the third semiconductor 253 switch is an NPN-type BJT. The base of the third semiconductor 253 is connected to the interconnection between the the zener diode 241 and the resistor 242 through a base resistor 255.

When the collector-emitter voltage *v_{ce}* does not exceed a maximum voltage set for it, the zener diode 241 does not conduct current. Therefore, there is no voltage difference between the base terminal and the emitter terminal of the third switch 253, i.e. the base-emitter voltage of the third switch is zero, and no current through the base terminal of the third switch 253. The third switch 253 is, thus, in non-conducting state. As a result, the resistor 254 is able to pull the voltage between the gate and the emitter, i.e. the gate-emitter voltage *v_{ge},* of the second switch 251 to a level which drives the second switch 251 to a conducting state. The second switch 251 in the conducting state provides a low-impedance route between the second supply voltage input *vₑₑ* and the negative voltage source 23.

When the collector-emitter voltage *v_{ce}* terminal exceeds a set maximum voltage, the zener diode 241 starts to conduct, and a current through the zener diode 241 and the resistor 242 generates a base-emitter voltage which sets the third switch 253 to a conducting state. As a result, the gate-source voltage of the second switch 251 is driven to zero. As a result, the second switch 251 switches into the non-conducting state, and the resistance of the connection between the second supply voltage input *vₑₑ* and the negative voltage source 23 increases.

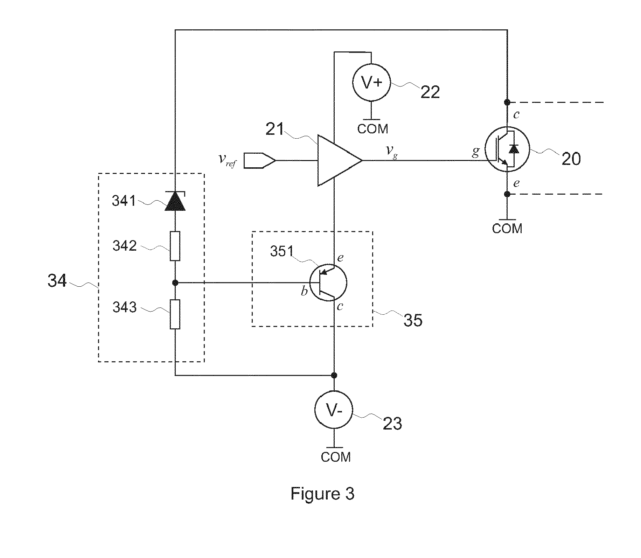

Figure 3 illustrates another exemplary arrangement implementing the disclosed method. The arrangement of Figure 3 differs from the arrangement of Figure 2 by its means 34 for determining an overvoltage and by its means 35 for adjusting the voltage at the second supply voltage *vₑₑ* of the gate driver unit 21.

In Figure 3, the means 34 for determining an overvoltage are implemented by a series connection of a zener diode 341 and two resistances 342 and 343 between the collector terminal *c* and the emitter terminal *e* of the IGBT 20. The zener diode 341 acts as the means for comparing the voltage between the first terminal and the second terminal, i.e. the collector-emitter voltage *v_{ce},* to a set voltage level, while the resistors 342 and 343 act as the means for producing an overvoltage detection signal on the basis of the comparison.

In Figure 3, the means 35 for adjusting the voltage at the second supply voltage input *vₑₑ* are implemented by a second semiconductor 351 switch between the second supply voltage input *vₑₑ* and the negative voltage source 23. In the arrangement of Figure 3, the second switch 351 is a PNP-type BJT which is directly controlled by the means 34 for determining an overvoltage. The base terminal of the second switch 351 is connected to the interconnection between the two resistances 342 and 343 of the means 34 for determining the overvoltage.

When the collector-emitter voltage *v_{ce}* of the IGBT 20 does not exceed a maximum voltage set for it, the zener diode 341 does not conduct current. Therefore, a voltage between an emitter terminal and a base terminal, i.e. an emitter-base voltage, of the second switch 351 is at a level which drives the the second switch 351 into saturation region. Thus, the second switch 351 provides a low-impedance path between the second supply voltage input *vₑₑ* and the negative voltage source 23.

When the collector-emitter voltage *v_{ce}* of the IGBT 20 exceeds the set voltage limit, the zener diode 341 starts to conduct, and a current through the zener diode 341 and the resistors 342 and 343 generates a voltage over the resistor 343. The voltage over the resistor 243 reduces the emitter-base voltage of the second switch 351 such that the second switch 351 switches into active region, and a voltage difference between the second supply voltage input *vₑₑ* and the negative voltage source 23 increases.

It is obvious to a person skilled in the art that the inventive concept can be implemented in various ways. The invention and its embodiments are not limited to the examples described above but may vary within the scope of the claims. In Figures 2 and 3, the transistors in the means 25 and 35 for adjusting voltage at the second supply voltage input can, for example, be replaced with other kind of semiconductor switches.

## Claims

1. An arrangement comprising
a first semiconductor switch (10) comprising a first terminal (*e*), a second terminal (*c*), and a third terminal (*g*), wherein the first switch (10) is adapted to control a current between the first terminal (*e*) and second terminal (*c*) on the basis of a control signal (*v_{g}*) supplied to the third terminal (*g*), wherein the control signal (*v_{g}*) has a first level for controlling the first switch (10) to a conducting state and a second level for controlling the first switch (10) to a non-conducting state,
a driver unit (11) comprising an output providing the control signal(*v_{g}*) to the third terminal (*g*) of the first switch (10), a first supply voltage input (*v_{cc}*) for providing an upper limit level of an operational range of the control signal (*v_{g}*), and a second supply voltage input (*vₑₑ*) for providing a lower limit level of the operational range of the control signal (*v_{g}*),
means (12, 13) for supplying a first voltage to the first supply voltage input (*v_{ec}*) and a second voltage to the second supply voltage input (*vₑₑ*),
means (14) for determining an overvoltage between the first terminal (*e*) and the second terminal (*c*) of the first switch (10), and
means (15) for adjusting the voltage at the second supply voltage input (*vₑₑ*) on the basis of the overvoltage between the first terminal (*e*) and the second terminal (*c*) of the first switch (10).

2. An arrangement according to claim 1, wherein the means (24) for determining an overvoltage comprises
means (241) for comparing the voltage between the first terminal (*e*) and the second terminal (*c*) of the first switch (20) with a set voltage level, and
means (242, 243) for producing an overvoltage detection signal on the basis of the comparison.

3. An arrangement according to claim 1 or 2, wherein the arrangement comprises
a series connection of a zener diode (241) and a resistance (242) between the first terminal (*e*) and the second terminal (*c*) of the first switch (20), wherein the zener diode (241) is configured to conduct current when the voltage between the first terminal (*e*) and the second terminal (*c*) exceeds the set voltage level, and the resistance (242) is configured to produce an overvoltage detection voltage responsive to the current through the zener diode (241).

4. An arrangement according to claim 1 or 2, wherein the arrangement comprises
a series connection of a zener diode (341) and two resistances (342, 343) between the first terminal (*e*) and the second terminal (*c*) of the first switch (20), wherein the zener diode (341) is configured to conduct current when the voltage between the first terminal (*e*) and the second terminal (*c*) exceeds the set voltage level, and the two resistances (342, 343) are configured to produce an overvoltage detection voltage responsive to the current through the zener diode (341).

5. An arrangement as claimed in any one of the preceding claims, wherein the means (25) for adjusting the second voltage comprise
means for adjusting an impedance of a connection between the second voltage supply input (*vₑₑ*) and the means (23) for supplying the second voltage on the basis of the overvoltage between the first terminal (*e*) and the second terminal (*c*) of the first switch (20).

6. An arrangement as claimed in any one of the preceding claims, wherein the means (25) for adjusting the voltage at the second supply voltage input (*vₑₑ*) comprise
a parallel connection of a second semiconductor (251) switch and a resistance (252) in between the second supply voltage input (*vₑₑ*) and the means (23) for supplying the second voltage, wherein the second switch (251) is configured to switch between a conducting state and a non-conducting state responsive to a voltage (*v_{ce}*) between the first terminal (*e*) and the second terminal (*c*) of the first switch (20) in such a manner that when the voltage (*v_{ce}*) between the first terminal (*e*) and the second terminal (*c*) of the first switch (20) exceeds the set voltage level, the second switch (251) switches into a non-conducting state.

7. An arrangement as claimed in any one of claims 1 to 5, wherein the means (35) for adjusting the voltage at the second supply voltage input (*vₑₑ*) comprise
a second semiconductor (351) switch between the second supply voltage input (*vₑₑ*) and the means (23) for supplying the second voltage, wherein the second switch (351) is configured to switch between saturation region and active region responsive to a voltage (*v_{ce}*) between the first terminal (*e*) and the second terminal (*c*) of the first switch (20) in such a manner that when the voltage (*v_{ce}*) between the first terminal (*e*) and the second terminal (*c*) of the first switch (20) exceeds the set voltage level, the second switch (351) switches into active region.

8. An arrangement as claimed in any one of claims 1 to 4, wherein the means (25) for adjusting the voltage at the second supply voltage input (*vₑₑ*) comprise
means for disconnecting a connection between the second voltage supply input (*vₑₑ*) and the means (23) for supplying the second voltage on the basis of the overvoltage between first terminal (*e*) and the second terminal (*c*) of the first switch (20).

9. A method for an arrangement comprising
a first semiconductor switch (10) comprising a first terminal (*e*), a second terminal (*c*), and a third terminal (*g*), wherein the first switch (10) is adapted to control a current between the first terminal (*e*) and second terminal (*c*) on the basis of a control signal (*v_{g}*) supplied to the third terminal (*g*), wherein the control signal (*v_{g}*) has a first level for controlling the first switch (10) to a conducting state and a second level for controlling the first switch (10) to a non-conducting state,
a driver unit (11) comprising an output providing the control signal(*v_{g}*) to the third terminal (*g*) of the first switch (10), a first supply voltage input (*v_{cc}*) for providing an upper limit level of an operational range of the control signal (*v_{g}*), and a second supply voltage input (*vₑₑ*) for providing a lower upper limit level of an operational range of the control signal (*v_{g}*),
means (12, 13) for supplying a first voltage to the first supply voltage input (*v_{ec}*) and a second voltage to the second supply voltage input (*vₑₑ*), wherein the method comprises
determining an overvoltage between the first terminal (*e*) and the second terminal (*c*) of the first switch (10), and
adjusting the voltage at the second supply voltage input (*vₑₑ*) on the basis of the overvoltage between the first terminal (*e*) and the second terminal (*c*) of the first switch (10).
